# EUROPÄISCHE PATENTSCHRIFT

(11) **EP 3 583 668 B1**
(45) Veröffentlichungstag und Bekanntmachung des Hinweises auf die Patenterteilung: **08.07.2020**
(21) Anmeldenummer: 18717502.1
(22) Anmeldetag: 09.03.2018
(51) Int. Cl.: H02B 1/56, H05K 7/20

(54) **ENTWÄRMUNGSANORDNUNG FÜR EINEN SCHALTSCHRANK**
HEAT DISSIPATION DEVICE FOR AN ELECTRICAL CABINET
DISPOSITIF DE DISSIPATION DE LA CHALEUR POUR ARMOIRE ÉLECTRIQUE

(30) Priorität: 09.05.2017 DE 102017109997
(43) Veröffentlichungstag der Anmeldung: 25.12.2019
(73) Patentinhaber: Rittal GmbH & Co. KG, 35745 Herborn (DE)
(72) Erfinder: MALZACHER, Dietrich, 57629 Norken (DE); DEUSING, Markus, 35688 Dillenburg (DE); GEORG, Markus, 35767 Breitscheid (DE); HARTMANN, Dietmar, 57076 Siegen (DE)
(74) Vertreter: Angerhausen, Christoph
(86) Internationale Anmeldenummer: PCT/DE2018/100216
(87) Internationale Veröffentlichungsnummer: WO 2018/206030

(56) Entgegenhaltungen:
- US-A1- 2010 134 972
- US-A1- 2015 373 872
- US-A1- 2016 234 974

## Beschreibung

Die Erfindung geht aus von einer Entwärmungsanordnung für einen Schaltschrank, die ein Schaltschrankgehäuse und ein im Innenraum dieses aufgenommenes, an einer Rückwand des Schaltschrankgehäuses montiertes Baugruppengehäuse zur Aufnahme mindestens einer eine thermische Verlustleistung aufweisenden Komponente aufweist. Das Baugruppengehäuse weist mindestens einen Lüfter, einen Kühllufteinlass und einen Warmluftauslass auf, wobei über den Lüfter Kühlluft aus dem Schaltschrankgehäuse in das Baugruppengehäuse hinein, durch das Baugruppengehäuse hindurch und über den Warmluftauslass als erwärmte Kühlluft aus dem Baugruppengehäuse herausgeführt ist. Eine derartige Entwärmungsanordnung ist aus der DE 10 2007 040 594 A1 bekannt. Weitere Anordnungen zum Kühlen von in Schaltschränken angeordneten elektrischen Komponenten sind in der US20100134972 A1 und US20160234974 A1 beschrieben.

Bei den aus dem Stand der Technik bekannten Entwärmungsanordnungen ist es üblich, die für die Abführung der Verlustleistung erforderliche Kühlluft zumindest bedarfsweise bei hohen Umgebungstemperaturen über einen Kompressorkreislauf, etwa eine Kältemaschine, zur Verfügung zu stellen, die zumindest dann aktiv ist, wenn eine passive Kühlung des Baugruppengehäuses im Umluftbetrieb, bei dem Luft aus dem Inneren des Schaltschrankgehäuses in das Baugruppengehäuse eingeblasen und als erwärmte Luft wieder in den Innenraum des Schaltschranks zurückgeblasen wird, unzureichend ist. Dies ist immer dann der Fall, wenn die Umgebungstemperatur des Schaltschrankgehäuses so hoch sind, dass die für eine dissipative Kühlung der im Schaltschrankinnenraum aufgenommene Luft über die Schaltschrankgehäuseoberfläche erforderliche Temperaturdifferenz zwischen Schaltschrankinnenraum und Umgebung des Schaltschrankgehäuses nicht vorliegt. Kompressorbetriebene Kühlkreisläufe, oder auch Kühlkreisläufe, welche mit einem aktiven Luft-/Luft-Wärmetauscher ausgestattet sind, weisen jedoch einen vergleichsweise hohen Energieverbrauch auf.

Es ist daher die Aufgabe der Erfindung, eine Entwärmungsanordnung der zuvor beschriebenen Art derart weiterzuentwickeln, dass sie die energieeffiziente Kühlung der in dem Baugruppengehäuse aufgenommenen Komponenten ermöglicht.

Diese Aufgabe wird durch eine Entwärmungsanordnung mit den Merkmalen des Anspruchs 1 gelöst. Der nebengeordnete Anspruch 11 betrifft ein entsprechendes Verfahren für die Entwärmung eines Schaltschrankgehäuses. Beispielhafte Ausführungsformen sind Gegenstand der abhängigen Ansprüche.

Demgemäß ist bei einer Entwärmungsanordnung der eingangs beschriebenen Art vorgesehen, dass der Warmluftauslass des Baugruppengehäuses in einen Warmlufteinlass eines Luftführungskanals in der Rückwand des Schaltschrankgehäuses mündet, wobei der Luftführungskanal durch die Rückwand geführt und mit einer Außenseite der Rückwand thermisch gekoppelt und/oder von dieser begrenzt ist, und wobei mindestens ein Kühlluftauslass des Luftführungskanals in den Innenraum des Schaltschrankgehäuses mündet.

Dadurch, dass bei der beschriebenen Entwärmungsanordnung die Rückwand die Funktion eines Wärmetauschers aufweist, bei dem über den Luftführungskanal zu entwärmende Luft durch die Rückwand geführt wird und der Luftführungskanal mit einer Außenseite der Rückwand thermisch gekoppelt ist, wird die dissipative Rückkühlleistung des Schaltschrankgehäuses gegenüber den aus dem Stand der Technik bekannten Schaltschrankgehäusen erhöht, so dass auch für geringere Differenzen ΔT zwischen Schaltschrankinnenraumtemperatur und Umgebungstemperatur noch eine ausreichende Rückkühlung der im Schaltschrankgehäuse enthaltenen Luft gewährleistet ist und dementsprechend auf die Verwendung energieuneffizienter Mittel zur Kälteerzeugung, insbesondere auf Kältemaschinen und dergleichen verzichtet werden kann.

Der Warmlufteinlass kann um einen vertikalen Abstand oberhalb von dem Kühlluftauslass angeordnet sein. Dadurch kann erreicht werden, dass die zu kühlende Luft im Wesentlichen in vertikaler Richtung durch die Rückwand geführt und insbesondere in einem unteren Bereich des Schaltschrankgehäuses zurück in den Innenraum des Schaltschrankgehäuses eingeleitet wird, um beispielsweise über die Unterseite des Baugruppengehäuses als gekühlte Luft über den Kühllufteinlass des Baugruppengehäuses angesogen zu werden.

Der Luftführungskanal kann dem Warmlufteinlass in Luftströmungsrichtung durch den Luftführungskanal unmittelbar nachgelagert oder diesem beigeordnet einen weiteren Warmluftauslass aufweisen, der mittelbar oder unmittelbar zur Umgebung des Schaltschrankgehäuses geöffnet ist. Dies ermöglicht es, dass aufgrund eines lokalen Luftüberdrucks in dem Luftführungskanal ein Teil der Warmluft aus dem Schaltschrankgehäuse ausgeblasen wird.

Beispielsweise kann der weitere Warmluftauslass in eine Dachgaube des Schaltschrankgehäuses münden, die wiederum zur Umgebung des Schaltschrankgehäuses entlüftet ist.

Der Luftführungskanal kann dem Kühlluftauslass in Luftströmungsrichtung durch den Luftführungskanal unmittelbar vorgelagert oder diesem beigeordnet einen weiteren Kühllufteinlass aufweisen, der zur Umgebung des Schaltschrankgehäuses geöffnet ist. Dies ermöglicht es, dass entsprechend dem Venturi-Effekt aufgrund der an dem Kühllufteinlass vorbeiströmenden abgekühlten Warmluft, kühle Luft aus der Schaltschankumgebung in den Luftführungskanal gesogen wird.

Der weitere Kühllufteinlass kann in einen Sockel des Schaltschrankgehäuses unterhalb des Innenraums münden, wobei der Sockel wiederum zur Umgebung des Schaltschrankgehäuses belüftet ist.

Der Luftführungskanal ist mäanderförmig durch die Rückwand geführt. Dadurch wird bei gegebener Luftströmungsgeschwindigkeit die Verweildauer der die Rückwand durchströmenden Luft und damit die thermische Kontaktdauer mit der Außenseite der Rückwand und dementsprechend ein noch effektiverer Abtausch der in der Luft enthaltenen thermischen Energie an die Umgebung des Schaltschrankgehäuses erreicht.

Die Rückwand kann eine dem Innenraum des Schaltschrankgehäuses zugewandte Innenseite und eine unter einem Abstand zu der Innenseite angeordnete und der Umgebung des Schaltschrankgehäuses zugewandte Außenseite aufweisen, wobei der Luftführungskanal von der Außenseite und von der Innenseite begrenzt ist. Die Rückwand kann beispielsweise doppelwandig ausgeführt sein, mit zwei parallel beabstandeten Seiten, von denen eine erste Seite die Innenseite und eine zweite Seite die Außenseite bildet. Der Luftführungskanal kann in der Richtung senkrecht zu der Rückwand gerade durch die Außenseite und die Innenseite begrenzt sein. Zwischen der Innenseite und der Außenseite der Rückwand können Luftleitelemente aufgenommen sein, welche verhindern, dass die durch die Rückwand geführte Luft auf kürzestem Wege von dem Warmlufteinlass zu dem Kühlluftauslass gelangt, so dass die effektive Verweildauer der Kühlluft in der Rückwand bei gegebener Strömungsgeschwindigkeit der Luft erhöht und damit der Wärmeabtausch der durch die Rückwand geleiteten Luft an die Umgebung des Schaltschrankgehäuses über die komplette Oberfläche der Rückwand entsprechend verbessert wird.

Zwischen der Innenseite und der Außenseite sowie angrenzend an diese kann sich mindestens ein Luftleitelement erstrecken, über das die durch den Luftführungskanal geleitete Luft mäanderförmig geführt ist.

Eine Mehrzahl paralleler und horizontaler Luftleitelemente kann sich zwischen der Innenseite und der Außenseite erstrecken, wobei die Luftleitelemente zwischen sich den Luftführungskanal begrenzen, sich abwechselnd ausgehend von gegenüberliegenden Stirnseiten der Rückwand erstrecken und jeweils unter Einhaltung eines Abstands bis an die jeweils gegenüberliegende Stirnseite heranreichen.

Gemäß einem anderen Aspekt wird ein Verfahren für die Entwärmung eines Schaltschrankgehäuses beschrieben, das die Schritte aufweist:
- Einblasen von Warmluft aus einem im Innenraum des Schaltschrankgehäuses aufgenommenen, an einer Rückwand des Schaltschrankgehäuses montierten Baugruppengehäuse zur Aufnahme mindestens einer eine thermische Verlustleistung aufweisenden Komponente in einen durch die Rückwand geleiteten Luftführungskanal;
- Durchleiten der Warmluft durch den Luftführungskanal und Ausblasen der Warmluft als gekühlte Luft in den Innenraum des Schaltschranks; und
- Einleiten der gekühlten Luft im Innenraum des Schaltschrankgehäuses in das Baugruppengehäuse
Bei dem Ausblasen der gekühlten Luft in den Innenraum des Schaltschrankgehäuses wird vorzugsweise Umgebungsluft der gekühlten Luft beigemengt, was insbesondere dann sinnvoll ist, wenn die durch die ausschließliche Zirkulation der Schaltschrankinnenraumluft durch die Rückwand erzielbare Kühlleistung nicht ausreichend ist.

Ebenso wird vorzugsweise bei dem Einblasen von Warmluft in den Luftführungskanal ein Teil der Warmluft in die Umgebung entlassen.

Weitere Einzelheiten der Erfindung werden anhand der nachstehenden Figuren erläutert. Diese zeigen:
- Figur 1: eine Entwärmungsanordnung in perspektivischer Sicht auf die Vorderseite sowie mit entfernten Türelementen;
- Figur 2: die Ausführungsform gemäß Figur 1 mit perspektivischer Sicht auf die Vorderseite von schräg unten; und
- Figur 3: eine Rückansicht der Ausführungsform gemäß den Figuren 1 und 2, wobei zur besseren Veranschaulichung die Außenseite der Rückwand des Schaltschrankgehäuses entfernt wurde.

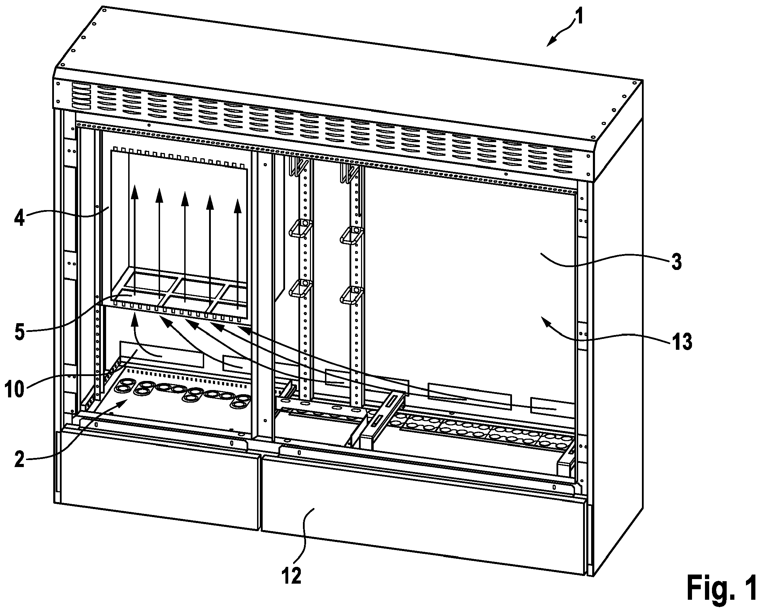

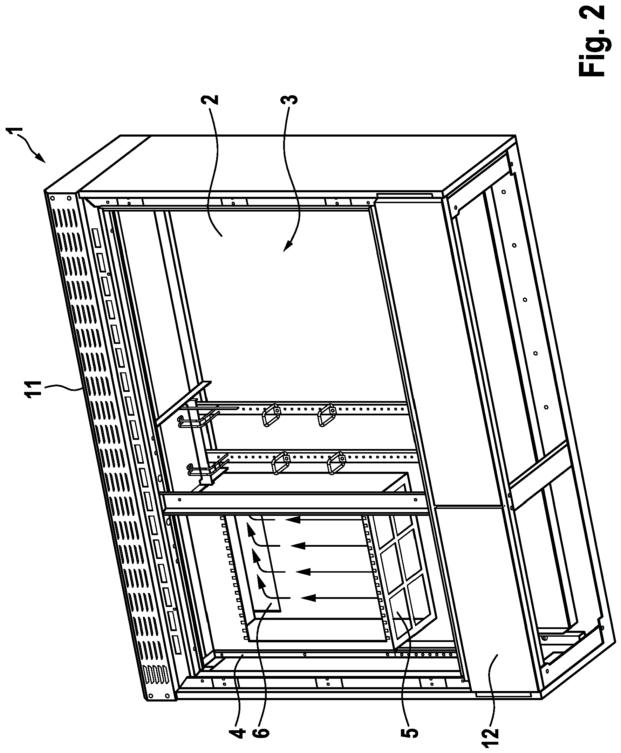

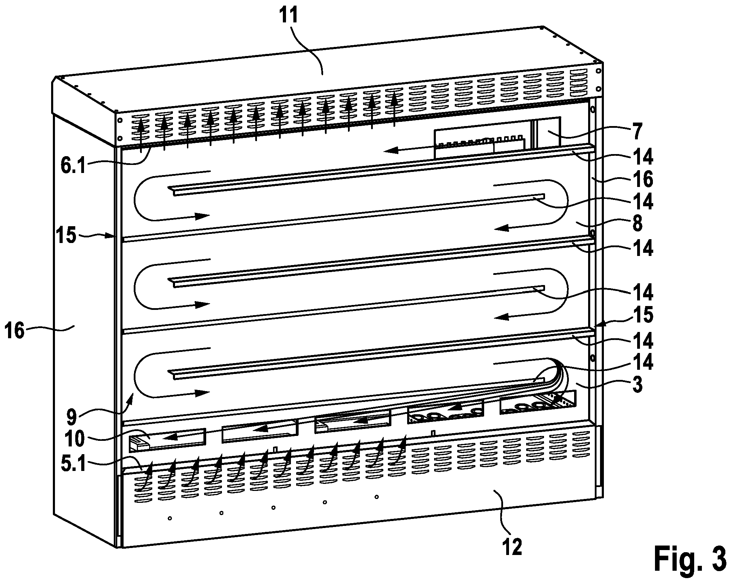

Die in den Figuren 1 bis 3 gezeigte Entwärmungsanordnung ist ein sogenanntes Multifunktionsgehäuse, welches insbesondere für Telekommunikationsanwendungen verwendet wird. Das Schaltschrankgehäuse 1 weist in seinem Innenraum 2 ein Baugruppengehäuse 4 auf, innerhalb welches eine Verlustleistung aufweisende und kühlungsbedürftige Komponenten aufgenommen sind. Diese Komponenten können beispielsweise die Komponenten eines MSAN (Multi Service Access Node) sein.

Das Baugruppengehäuse 4 weist mindestens einen Lüfter (nicht dargestellt) auf, über den Kühlluft aus dem Schaltschrankinnenraum über mindestens einen Kühllufteinlass 5 in das Baugruppengehäuse 4 eingeblasen ist. Der Kühllufteinlass 5 ist an einer Unterseite des Baugruppengehäuses 4 angeordnet. An einem der Unterseite abgewandten oberen Ende weist das Baugruppengehäuse 4 einen Warmluftauslass 6 auf, der über eine Innenseite 13 in eine als Doppelwand ausgebildete Rückwand 3 mündet, so dass die Warmluft aus dem Baugruppengehäuse 4 unmittelbar in einen Zwischenraum zwischen der Innenseite 13 und der Außenseite 9 der Rückwand 3 eingeleitet ist.

Zwischen der Innenseite 13 und der Außenseite 9 der Rückwand 3 ist eine Mehrzahl Luftleitelemente 14 angeordnet, welche im Zusammenwirken mit der Innenseite 13 und der Außenseite 9 einen Luftführungskanal 8 bilden, über den die über den Warmlufteinlass 7 in den Luftführungskanal 8 eintretende Warmluft mäanderförmig von einem oberen Ende der Rückwand 3 zu einem unteren Ende der Rückwand 3 geführt wird, um dort über Kühlluftauslässe 10 zurück in den Innenraum 2 des Schaltschrankgehäuses 1 geführt zu werden.

Unmittelbar nachdem die Warmluft über den Warmlufteinlass 7 in den Luftführungskanal 8 eingetreten ist, erstreckt sich der Luftführungskanal 8 zunächst in einer Horizontalrichtung, so dass die Warmluft entlang des oberen Endes der Rückwand 3 sowie unmittelbar unterhalb einer Dachgaube 11 des Schaltschrankgehäuses 1 senkrecht zu den gegenüberliegenden Seitenwänden 16 beziehungsweise senkrecht zur den Stirnseiten 15 der Rückwand 3 geführt ist. Der Luftführungskanal 8 weist in diesem ersten Abschnitt unmittelbar dem Warmlufteinlass in Luftströmungsrichtung nachgelagert einen weiteren Warmluftauslass 6.1 auf, der in die Dachgaube 11 mündet, so dass zumindest ein Teil der über den Warmlufteinlass 7 in den Luftführungskanal 8 einströmenden Warmluft über den weiteren Warmlufteinlass 6.1 in die Dachgaube 11 und über diese in die Umgebung des Schaltschrankgehäuses 1 entweichen kann.

Am unteren Ende des Luftführungskanals wird die abgekühlte Warmluft, bevor sie über eine Mehrzahl Kühlluftauslässe 10 zurück in den Innenraum 2 des Schaltschranks 1 eintritt, an einer Mehrzahl Kühllufteinlässe 5.1 vorbeigeführt, die zur Umgebung des Schaltschrankgehäuses 1 geöffnet sind. Da sich die gekühlte Luft im Wesentlichen parallel zum Öffnungsquerschnitt der weiteren Kühllufteinlässe 5.1 bewegt, wird aufgrund des Venturi-Effekts kühle Umgebungsluft über die weiteren Kühllufteinlässe 5.1 in den Luftführungkanal 8 eingesogen und mit der abgekühlten Warmluft zurück in den Innenraum 2 des Schaltschrankgehäuses 1 transportiert. Auf diese Weise wird eine zusätzliche Kühlleistung bereitgestellt. Die weiteren Kühllufteinlässe 5.1 können in den Sockel 12 des Schaltschrankgehäuses 1 unterhalb des Innenraums 2 münden, wobei der Sockel 12 wiederum zur Umgebung des Schaltschrankgehäuses 1 belüftet ist.

Die Mehrzahl paralleler und horizontaler Luftleitelemente 14 erstreckt sich zwischen der Innenseite 13 und der Außenseite 9, wobei die Luftleitelemente 14 zwischen sich den Luftführungskanal 8 in Vertikalrichtung begrenzen. Die Luftleitelemente 14 erstrecken sich weiterhin abwechselnd ausgehend von gegenüberliegenden Stirnseiten 15 der Rückwand 3 und reichen jeweils unter Einhaltung eines Abstands bis an die jeweils gegenüberliegende Stirnseite heran. Auf diese Weise wird erreicht, dass zwischen der Innenseite 13 und der Außenseite 9 sowie zwischen den benachbarten Luftleitelementen der Luftführungskanal 8 gebildet ist, durch den die über den Warmlufteinlass 7 eintretende Warmluft zur möglichst effektiven Abkühlung mäanderförmig bis zu den Kühlluftauslässen 10 des Luftführungskanals 8 geführt ist.

Die in der vorstehenden Beschreibung, in den Zeichnungen sowie in den Ansprüchen offenbarten Merkmale der Erfindung können sowohl einzeln als auch in beliebiger Kombination für die Verwirklichung der Erfindung wesentlich sein.

### Bezugszeichenliste

- 1: Schaltschrankgehäuse
- 2: Innenraum
- 3: Rückwand
- 4: Baugruppengehäuse
- 5: Kühllufteinlass
- 5.1: weiterer Kühllufteinlass
- 6: Warmluftauslass
- 6.1: weiterer Warmluftauslass
- 7: Warmlufteinlass
- 8: Luftführungskanal
- 9: Außenseite
- 10: Kühlluftauslass
- 11.: Dachgaube
- 12: Sockel
- 13: Innenseite
- 14: Luftleitelement
- 15: Stirnseite
- 16: Seitenwand

## Patentansprüche

1. Entwärmungsanordnung für einen Schaltschrank, die ein Schaltschrankgehäuse (1) und ein im Innenraum (2) dieses aufgenommenes, an einer Rückwand (3) des Schaltschrankgehäuses (1) montiertes Baugruppengehäuse (4) zur Aufnahme mindestens einer eine thermische Verlustleistung aufweisenden Komponente aufweist, wobei das Baugruppengehäuse (4) mindestens einen Lüfter, einen Kühllufteinlass (5) und einen Warmluftauslass (6) aufweist, wobei über den Lüfter Kühlluft aus dem Schaltschrankgehäuse (1) in das Baugruppengehäuse (4) hinein, durch das Baugruppengehäuse (4) hindurch und über den Warmluftauslass (6) als erwärmte Kühlluft aus dem Baugruppengehäuse (4) herausgeführt ist, wobei der Warmluftauslass (6) des Baugruppengehäuses (4) in einen Warmlufteinlass (7) eines Luftführungskanals (8) in der Rückwand (3) des Schaltschrankgehäuses (1) mündet, wobei der Luftführungskanal (8) durch die Rückwand (3) geführt und mit einer Außenseite (9) der Rückwand (3) thermisch gekoppelt und/oder von dieser begrenzt ist, und wobei mindestens ein Kühlluftauslass (10) des Luftführungskanals (8) in den Innenraum (2) des Schaltschrankgehäuses (1) mündet, **dadurch gekennzeichnet, dass** der Luftführungskanal (8) mäanderförmig durch die Rückwand (3) geführt ist

2. Entwärmungsanordnung nach Anspruch 1, bei der der Warmlufteinlass (7) um einen vertikalen Abstand oberhalb von dem Kühlluftauslass (10) angeordnet ist.

3. Entwärmungsanordnung nach Anspruch 1 oder 2, bei der der Luftführungskanal (8) dem Warmlufteinlass (7) in Luftströmungsrichtung durch den Luftführungskanal (8) unmittelbar nachgelagert oder diesem beigeordnet einen weiteren Warmluftauslass (6.1) aufweist, der mittelbar oder unmittelbar zur Umgebung des Schaltschrankgehäuses (1) geöffnet ist.

4. Entwärmungsanordnung nach Anspruch 3, bei der der weitere Warmluftauslass (6.1) in eine Dachgaube (11) des Schaltschrankgehäuses (1) mündet, die zur Umgebung des Schaltschrankgehäuses (1) entlüftet ist.

5. Entwärmungsanordnung nach einem der vorangegangen Ansprüche, bei der der Luftführungskanal (8) dem Kühlluftauslass (10) in Luftströmungsrichtung durch den Luftführungskanal (8) unmittelbar vorgelagert oder diesem beigeordnet einen weiteren Kühllufteinlass (5.1) aufweist, der zur Umgebung des Schaltschrankgehäuse (1) geöffnet ist.

6. Entwärmungsanordnung nach Anspruch 5, bei der der weitere Kühllufteinlass (5.1) in einen Sockel (12) des Schaltschrankgehäuses (1) unterhalb des Innenraums (2) mündet, der zur Umgebung des Schaltschrankgehäuses (1) belüftet ist.

7. Entwärmungsanordnung nach einem der vorangegangen Ansprüche, bei der die Rückwand (3) eine dem Innenraum (2) des Schaltschrankgehäuses (1) zugewandte Innenseite (13) und eine unter einem Abstand zu der Innenseite (13) angeordnete und der Umgebung des Schaltschrankgehäuses (1) zugewandte Außenseite (9) aufweist, wobei der Luftführungskanal (8) von der Außenseite (9) und der Innenseite (13) begrenzt ist.

8. Entwärmungsanordnung nach Anspruch 7, bei der sich zwischen der Innenseite (13) und der Außenseite (9) und angrenzend an diese mindestens ein Luftleitelement (14) erstreckt, über das die durch den Luftführungskanal (8) geleitete Luft mäanderförmig geführt ist.

9. Entwärmungsanordnung nach Anspruch 7 oder 8, bei der sich eine Mehrzahl paralleler und horizontaler Luftleitelemente (14) zwischen der Innenseite (13) und der Außenseite (9) erstrecken, die zwischen sich den Luftführungskanal (8) begrenzen und die sich abwechselnd ausgehend von gegenüber liegenden Stirnseiten (15) der Rückwand (3) erstrecken und jeweils unter Einhaltung eines Abstands bis an die jeweils gegenüber liegende Stirnseite (15) heranreichen.

10. Verfahren für die Entwärmung eines Schaltschrankgehäuses (1) nach einem der Ansprüche 1 bis 9, das die Schritte aufweist:
- Einblasen von Warmluft aus einem im Innenraum (2) des Schaltschrankgehäuses (1) aufgenommenen, an einer Rückwand (3) des Schaltschrankgehäuses (1) montierten Baugruppengehäuse (4) zur Aufnahme mindestens einer eine thermische Verlustleistung aufweisenden Komponente in einen durch die Rückwand (3) geleiteten Luftführungskanal (8);
- Durchleiten der Warmluft durch den Luftführungskanal (8) und Ausblasen der Warmluft als gekühlte Luft in den Innenraum (2) des Schaltschranks; und
- Einleiten der gekühlten Luft im Innenraum (2) des Schaltschrankgehäuses (1) in das Baugruppengehäuse (4),
**dadurch gekennzeichnet, dass** das Durchleiten der Warmluft das mäanderförmige Durchleiten der Warmluft durch den Luftführungskanal (8) aufweist.

11. Verfahren nach Anspruch 10, bei dem bei dem Ausblasen der gekühlten Luft in den Innenraum (2) des Schaltschrankgehäuses (1) Umgebungsluft der gekühlten Luft beigemengt wird.

12. Verfahren nach Anspruch 10 oder 11, bei dem bei dem Einblasen von Warmluft in den Luftführungskanal (8) ein Teil der Warmluft in die Umgebung entlassen wird.

13. Verfahren nach einem der Ansprüche 10 bis 12, bei dem bei dem Durchleiten Wärmeenergie der Warmluft über eine Außenseite (9) der Rückwand (3), welche den Luftführungskanal (8) begrenzt, abgetauscht wird.

## Claims

1. A heat dissipation arrangement for a switch cabinet, which has a switch cabinet housing (1) and a subassembly housing (4), which is accommodated in the interior (2) thereof and is mounted on a rear wall (3) of the switch cabinet housing (1), for accommodating at least one component having a thermal power loss, the subassembly housing (4) having at least one fan, a cooling air inlet (5) and a warm air outlet (6), wherein by means of the fan cooling air is guided from the switch cabinet housing (1) into the assembly housing (4), through the assembly housing (4) and out of the assembly housing (4) via the warm air outlet (6) as heated cooling air, wherein the warm air outlet (6) of the assembly housing (4) opens into a warm air inlet (7) of an air guide channel (8) in the rear wall (3) of the switch cabinet housing (1), wherein the air guide channel (8) is guided through the rear wall (3) and is thermally coupled to an outer side (9) of the rear wall (3) and/or is limited by the latter, and wherein at least one cooling air outlet (10) of the air duct (8) opens into the interior (2) of the switch cabinet housing (1), **characterised in that** the air duct (8) is guided in meandering manner through the rear wall (3).

2. The heat dissipation arrangement according to claim 1, in which the warm air inlet (7) is arranged at a vertical distance above the cooling air outlet (10).

3. The heat dissipation arrangement according to claim 1 or 2, in which the air duct (8) has a further warm air outlet (6.1) directly downstream of the warm air inlet (7) in the direction of air flow through the air duct (8) or associated therewith, which is open directly or indirectly to the surroundings of the switch cabinet housing (1).

4. The heat dissipation arrangement according to claim 3, in which the further warm air outlet (6.1) opens into a roof dormer (11) of the switch cabinet housing (1), which is vented to the surroundings of the switch cabinet housing (1).

5. The heat dissipation arrangement according to one of the preceding claims, in which the air duct (8) has a further cooling air inlet (5.1), which is open to the surroundings of the switch cabinet housing (1), directly upstream of the cooling air outlet (10) in the air flow direction through the air duct (8) or associated therewith.

6. The heat dissipation arrangement according to claim 5, in which the further cooling air inlet (5.1) opens into a base (12) of the switch cabinet housing (1) below the interior (2), which is ventilated to the surroundings of the switch cabinet housing (1).

7. The heat dissipation arrangement according to one of the preceding claims, in which the rear wall (3) has an inner side (13) facing the interior (2) of the switch cabinet housing (1) and an outer side (9) arranged at a distance from the inner side (13) and facing the surroundings of the switch cabinet housing (1), the air duct (8) being bounded by the outer side (9) and the inner side (13).

8. The heat dissipation arrangement according to claim 7, in which at least one air guide element (14) extends between the inner side (13) and the outer side (9) and adjoining the latter, over which air guide element the air conducted through the air guide channel (8) is guided, in particular in a meandering manner.

9. The heat dissipation arrangement according to claim 7 or 8, in which a plurality of parallel and horizontal air guide elements (14) extend between the inner side (13) and the outer side (9), which define between them the air guide channel (8) and which extend alternately starting from opposite end faces (15) of the rear wall (3) and in each case reach up to the respective opposite end face (15) while maintaining a distance.

10. A method for the heat dissipation of a switch cabinet housing (1), which comprises the steps:
- blowing warm air from a subassembly housing (4), which is accommodated in the interior (2) of the switchgear cabinet housing (1) and is mounted on a rear wall (3) of the switchgear cabinet housing (1), for accommodating at least one component, which has a thermal power loss, in an air duct (8) guided through the rear wall (3);
- passing the warm air through the air duct (8) and blowing the warm air as cooled air into the interior (2) of the switch cabinet; and
- introducing the cooled air in the interior (2) of the switch cabinet housing (1) into the subassembly housing (4),
**characterised in that** passing of the warm air comprises passing of the warm air through the air guide channel (8) in a meandering manner.

11. The method according to claim 10, in which ambient air is added to the cooled air during the blowing out of the cooled air into the interior (2) of the switch cabinet housing (1).

12. The method according to claim 10 or 11, in which, when warm air is blown into the air duct (8), part of the warm air is released into the environment.

13. The method according to one of claims 10 to 12, in which, when passing through, thermal energy of the warm air is exchanged via an outer side (9) of the rear wall (3) which delimits the air duct (8).

## Revendications

1. Dispositif de dissipation thermique pour une armoire de commande, qui comprend un boîtier d'armoire de commande (1) et un boîtier de sous-ensemble (4), logé dans l'espace interne (2) de celui-ci, monté sur une paroi arrière (3) du boîtier d'armoire de commande (1), pour le logement d'au moins un composant présentant une puissance de perte thermique, dans lequel le boîtier de sous-ensemble (4) comprend au moins un ventilateur, une entrée d'air froid (5) et une sortie d'air chaud (6), dans lequel, par l'intermédiaire du ventilateur, l'air froid est guidé hors du boîtier d'armoire de commande (1) vers le boîtier de sous-ensemble (4), à travers le boîtier de sous-ensemble (4) et par l'intermédiaire de la sortie d'air chaud (6) en tant qu'air froid chauffé hors du boîtier de sous-ensemble (4), dans lequel la sortie d'air chaud (6) du boîtier de sous-ensemble (4) débouche dans une entrée d'air chaud (7) d'un canal de guidage d'air (8) dans la paroi arrière (3) du boîtier d'armoire de commande (1), dans lequel le canal de guidage d'air (8) est guidé à travers la paroi arrière (3) et est couplé thermiquement avec un côté externe (9) de la paroi arrière (3) et/ou est limité par celle-ci et dans lequel au moins une sortie d'air froid (10) du canal de guidage d'air (8) débouche dans l'espace interne (2) du boîtier d'armoire de commande (1), **caractérisé en ce que** le canal de guidage d'air (8) est guidé en zigzag à travers la paroi arrière (3).

2. Dispositif de dissipation thermique selon la revendication 1, dans lequel l'entrée d'air chaud (7) est disposée à une distance verticale au-dessus de la sortie d'air froid (10).

3. Dispositif de dissipation thermique selon la revendication 1 ou 2, dans lequel le canal de guidage d'air (8) est disposé immédiatement après l'entrée d'air chaud (7) dans la direction d'écoulement de l'air à travers le canal de guidage d'air (8) ou comprend, associé à celui-ci, une autre sortie d'air chaud (6.1), qui est ouvert indirectement ou directement vers l'environnement du boîtier d'armoire de commande (1).

4. Dispositif de dissipation thermique selon la revendication 3, dans lequel l'autre sortie d'air chaud (6.1) débouche dans une lucarne (11) du boîtier d'armoire de commande (1), qui est ventilée vers l'environnement du boîtier d'armoire de commande (1).

5. Dispositif de dissipation thermique selon l'une des revendications précédentes, dans lequel le canal de guidage d'air (8) est disposé immédiatement avant la sortie d'air froid (10) dans la direction d'écoulement de l'air à travers le canal de guidage d'air (8) ou comprend, associé à celui-ci, une autre entrée d'air froid (5.1) qui est ouverte vers l'environnement du boîtier d'armoire de commande (1).

6. Dispositif de dissipation thermique selon la revendication 5, dans lequel l'autre entrée d'air froid (5.1) débouche dans un socle (12) du boîtier d'armoire de commande (1) en dessous de l'espace interne (2), qui est ventilé vers l'environnement du boîtier d'armoire de commande (1).

7. Dispositif de dissipation thermique selon l'une des revendications précédentes, dans lequel la paroi arrière (3) comprend un côté interne (13) orienté vers l'espace interne (2) du boîtier d'armoire de commande (1) et un côté externe (9) disposé à distance du côté interne (13) et orienté vers l'environnement du boîtier d'armoire de commande (1), dans lequel le canal de guidage d'air (8) est limité par le côté externe (9) et le côté interne (13).

8. Dispositif de dissipation thermique selon la revendication 7, dans lequel, entre le côté interne (13) et le côté externe (9) et, de manière adjacente à ceux-ci, s'étend un élément de guidage d'air (14) par l'intermédiaire duquel l'air guidé à travers le canal de guidage d'air (8) est guidé en zigzag.

9. Dispositif de dissipation thermique selon la revendication 7 ou 8, dans lequel une pluralité d'éléments de guidage d'air (14) parallèles et horizontaux s'étendent entre le côté interne (13) et le côté externe (9), qui délimitent entre eux le canal de guidage d'air (8), et qui s'étendent en alternance à partir de côtés avant (15) opposés de la paroi arrière (3) et qui atteignent chacun le côté avant (15) respectif qui lui fait face en respectant une distance.

10. Procédé pour la dissipation thermique d'un boîtier d'armoire de commande (1) selon l'une des revendications 1 à 9, qui comprend les étapes suivantes :
- soufflage d'air chaud provenant d'un boîtier de sous-ensemble (4) logé dans l'espace interne (2) du boîtier d'armoire de commande (1), monté sur une paroi arrière (3) du boîtier d'armoire de commande (1), pour le logement d'au moins un composant présentant une puissance de perte thermique, vers un canal de guidage d'air (8) guidé à travers la paroi arrière (3) ;
- passage de l'air chaud à travers le canal de guidage d'air (8) et soufflage de l'air chaud en tant qu'air refroidi vers l'espace interne (2) de l'armoire de commande ; et
- introduction de l'air refroidi dans l'espace interne (2) du boîtier d'armoire de commande (1) vers le boîtier de sous-ensemble (4),
**caractérisé en ce que** le passage de l'air chaud comprend le passage en zigzag de l'air chaud à travers le canal de guidage d'air (8).

11. Procédé selon la revendication 10, dans lequel, lors du soufflage de l'air refroidi vers l'espace interne (2) du boîtier d'armoire de commande (1), l'air ambiant est ajouté à l'air refroidi.

12. Procédé selon la revendication 10 ou 11, dans lequel, lors du soufflage de l'air chaud vers le canal de guidage d'air (8), une partie de l'air chaud est purgée vers l'environnement.

13. Procédé selon l'une des revendications 10 à 12, dans lequel, lors du passage, de l'énergie thermique de l'air chaud est échangée par l'intermédiaire d'un côté externe (9) de la paroi arrière (3), qui limite le canal de guidage d'air (8).
